# EUROPEAN PATENT SPECIFICATION

(11) **EP 3 868 918 B1**
(45) Date of publication and mention of the grant of the patent: **03.12.2025**
(21) Application number: 19872443.7
(22) Date of filing: 17.09.2019
(51) Int. Cl.: C23C 14/50, H05H 1/46, H01J 37/32, H01L 21/687

(54) **PLASMA FILM FORMATION APPARATUS AND PLASMA FILM FORMATION METHOD**
VORRICHTUNG UND VERFAHREN ZUR PLASMAFILMBILDUNG
APPAREIL DE FORMATION DE FILM DE PLASMA ET PROCÉDÉ CORRESPONDANT

(30) Priority: 16.10.2018 JP 2018194965
(43) Date of publication of application: 25.08.2021
(73) Proprietor: JSW AFTY Corporation, Tokyo 192-0918 (JP)
(72) Inventor: SHIMADA, Masaru, Hachioji City, Tokyo 192-0918 (JP); TORII, Hironori, Hachioji City, Tokyo 192-0918 (JP); TANAKA, Kozue, Hachioji City, Tokyo 192-0918 (JP)
(74) Representative: Casalonga
(86) International application number: PCT/JP2019/036408
(87) International publication number: WO 2020/080016

(56) References cited:
- JP-A- 2002 203 790
- JP-A- 2003 247 065
- JP-A- 2005 281 726
- JP-A- 2005 281 726
- JP-A- 2005 320 601
- JP-A- 2007 138 295
- JP-A- 2008 159 646
- JP-A- 2011 105 996
- JP-A- H0 610 143
- US-A1- 2005 257 744
- US-A1- 2009 098 306
- US-A1- 2017 047 225

## Description

### TECHNICAL FIELD

The present invention relates to a plasma film forming apparatus and a plasma film forming method for forming a film by irradiating a substrate such as a semiconductor substrate with plasma. In particular, the present invention relates to a plasma film forming apparatus according to the preamble of independent claim 1 and a plasma film forming method according to the preamble of independent claim 5, such as they are both known from US 2005/257744 A1.

### BACKGROUND ART

A technique is known in which the plasma generated by electron cyclotron resonance (ECR) is utilized and a voltage is applied to the ECR target arranged around the plasma, whereby ions contained in the plasma are accelerated and entered into the target to generate the sputtering phenomenon and target particles are adhered to a substrate to form a thin film.

As a manufacturing apparatus used for such a technique, for example, Japanese Unexamined Patent Application Publication No. 2005-281726 discloses a structure of a plasma film forming apparatus.

### RELATED ART DOCUMENTS

### PATENT DOCUMENTS

Patent Document 1: Japanese Unexamined Patent Application publication No. 2005-281726

### SUMMARY OF THE INVENTION

### PROBLEMS TO BE SOLVED BY THE INVENTION

Patent Document 1 mentioned above discloses a structure of a plasma film forming apparatus including a sample chamber in which a rotatable sample substrate is stored and a plasma generation chamber (plasma generation unit) provided with a plasma generation source and connected to the sample chamber.

In the plasma film forming apparatus mentioned above, plasma is generated by utilizing electron cyclotron resonance by the interaction of microwave and magnetic field in the plasma generation chamber, and the generated plasma is irradiated from an oblique direction onto the sample substrate rotating in the sample chamber by using the divergent magnetic field, thereby forming a film on the sample substrate. The size of the plasma generation chamber is limited to about the wavelength of microwave (for example, 2.45 GHz), and it is difficult to increase the size. Therefore, in the plasma film forming apparatus mentioned above, the plasma generation chamber is arranged to be inclined so as to prevent the increase in size, and the plasma is irradiated to the sample substrate from an oblique direction.

Also, by irradiating the plasma to the sample substrate from an oblique direction, the irradiation range of the plasma to be irradiated to the sample substrate can be widened. Note that it is conceivable to incline the angle of the holder that holds the sample substrate with respect to the horizontal direction without arranging the plasma generation chamber to be inclined, but in this case, the holding mechanism of the sample substrate is complicated and the size of the apparatus is increased.

In recent years, there has been an increasing demand for a large-diameter sample substrate having a diameter of more than 200 mm. In the sputtering apparatus using ECR plasma, as the size of the sample substrate increases, factors such as the adjustment of the placement position of the sample substrate have a greater influence on the uniformity of the film thickness by the sputtering.

As a result of performing a simulation on a large-diameter sample substrate having a diameter of more than 200 mm in the ECR plasma film forming apparatus in which the plasma generation chamber was arranged to be inclined, the inventors found that sufficient film thickness uniformity could not be obtained only by the adjustment of the position of the sample substrate in the vertical direction in the case of the large-diameter sample substrate having a diameter of more than 200 mm.

Namely, the inventors found that, in the ECR plasma film forming apparatus in which the plasma generation chamber (plasma generation unit) is arranged to be inclined, the control range was narrow if the adjustment of the position of the sample substrate was limited to the adjustment in the vertical direction, and the control range of the film thickness was insufficient for the sample substrate having a large diameter.

An object of the present invention is to provide a technique capable of making the film thickness uniform even in the case of a substrate having a large diameter in the plasma film forming process.

The above-described object and novel features of the present invention will become apparent from the description of this specification and accompanying drawings.

### MEANS FOR SOLVING THE PROBLEMS

An outline of a typical embodiment disclosed in this application will be briefly described as follows.

In order to solve the above problems the present invention provides a plasma film forming apparatus according to independent claim 1 and a plasma film forming method according to independent claim 5. The dependent claims relate to advantageous embodiments.

### EFFECTS OF THE INVENTION

The effects obtained by the typical invention disclosed in this application will be described as follows.

The control range of a film thickness of a film formed on a substrate can be widened in the plasma film forming process, and the film thickness can be made uniform even in the case of the substrate having a large diameter without increasing the size of the plasma film forming apparatus. Also, it is possible to form a high-quality thin film.

### BRIEF DESCRIPTIONS OF THE DRAWINGS

FIG. 1 is a schematic diagram showing a general configuration of a plasma film forming apparatus according to an embodiment of the present invention;
FIG. 2 is a schematic diagram showing a concept of movement of a substrate on the coordinate axes in the plasma film forming apparatus shown in FIG. 1;
FIG. 3(a) is a conceptual diagram of particle distribution at the time of sputtering in the plasma film forming apparatus shown in FIG. 1;
FIG. 3(b) is a conceptual diagram showing a shape of a film formed on a substrate;
FIG. 4(a) is a conceptual diagram of particle distribution at the time of sputtering in the plasma film forming apparatus shown in FIG. 1;
FIG. 4(b) is a conceptual diagram showing a shape of a film formed on a substrate;
FIG. 5(a) is a conceptual diagram of particle distribution at the time of sputtering in the plasma film forming apparatus shown in FIG. 1;
FIG. 5(b) is a conceptual diagram showing a shape of a film formed on a substrate;
FIG. 6 is a film thickness distribution diagram showing the distribution of film thickness on a substrate on which a film is formed using the plasma film forming apparatus shown in FIG. 1;
FIG. 7(a) is a schematic diagram showing the distribution of film thickness on a substrate based on the measured value of FIG. 6 in the case of Xs = 0 mm;
FIG. 7(b) is a schematic diagram showing the distribution of film thickness on a substrate based on the measured value of FIG. 6 in the case of Xs = 90 mm; and
FIG. 7(c) is a schematic diagram showing the distribution of film thickness on a substrate based on the measured value of FIG. 6 in the case of Xs > 90 mm.

### DETAILED DESCRIPTION OF PREFERRED EMBODIMENT

An embodiment of the present invention will be described with reference to drawings.

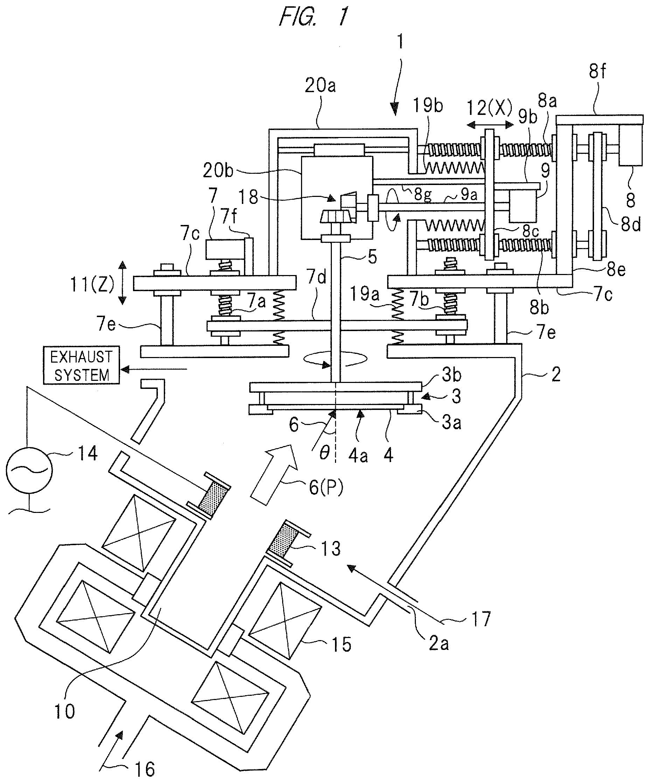

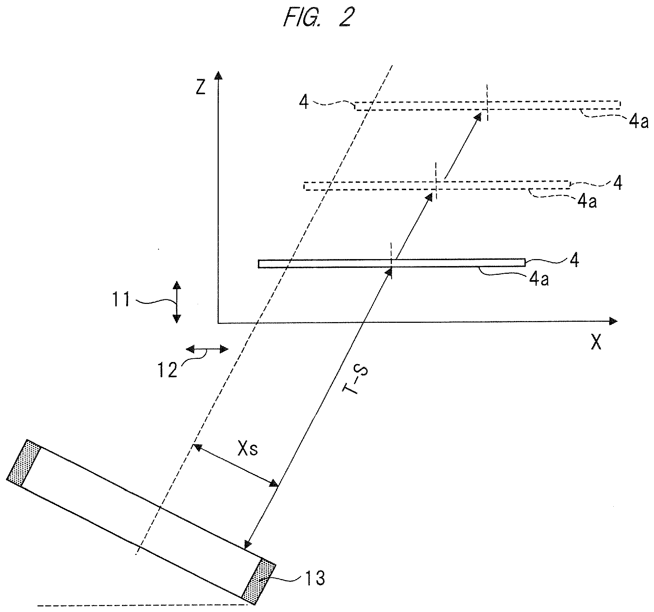

Hereinafter, an embodiment of the present invention will be described with reference to drawings. FIG. 1 is a schematic diagram showing a general configuration of a plasma film forming apparatus according to an embodiment of the present invention, and FIG. 2 is a schematic diagram showing a concept of movement of a substrate on the coordinate axes in the plasma film forming apparatus shown in FIG. 1.

In a plasma film forming apparatus 1 according to the present embodiment shown in FIG. 1, a plasma 6 is formed by generating ECR by the electric field of a microwave 16 and the magnetic field formed by a coil 15 provided around a plasma generation unit 10, and a film forming process by sputtering is performed by using the plasma 6 on a substrate 4 which is a sample such as a semiconductor wafer.

Also, in the plasma film forming apparatus 1 according to the present embodiment, the size of the substrate 4 on which the apparatus can form a film is, for example, 300 mm in diameter, and it is a film forming apparatus capable of performing the film forming process on the substrate 4 having a large diameter.

The plasma film forming apparatus 1 shown in FIG. 1 will be described. The plasma film forming apparatus 1 includes a vacuum chamber (vacuum container) 2 which is a process chamber in which the substrate 4 on which the film forming process is performed is placed and a plasma generation unit 10 which communicates with the vacuum chamber 2 and generates the plasma 6 in the vacuum chamber 2.

Further, a cylindrical target 13 is arranged at a position where the plasma generation unit 10 communicates with the vacuum chamber 2, that is, at the outlet of the plasma generation unit 10, and a sputtering material (film forming material) is provided on an inner wall of the target 13. At the time of film formation, RF (Radio Frequency) power 14 is applied to the target 13.

In addition, the coil 15 is provided around the plasma generation unit 10, and electrons in the plasma generated in the plasma generation unit 10 move into the vacuum chamber 2 along the magnetic field gradient. In doing so, ions are also drawn into the vacuum chamber 2 so as to be dragged by the potential formed by the electrons. At this time, by applying the RF power 14 to the target 13 to cause the ions in the plasma to collide with the target 13, a film can be formed on the substrate 4 by the sputtering action. When forming the film, process gas 17 is introduced from a gas introduction port 2a of the vacuum chamber 2. The arrow P in FIG. 1 indicates the flow of sputtered particles as well as the flow of the plasma 6.

Since the size of the plasma generation unit 10 is limited to about the wavelength (12.2 cm) of the microwave 16 of 2.45 GHz, it is difficult to increase the size.

Therefore, in the plasma film forming apparatus 1 according to the present embodiment, in order to obtain high film thickness uniformity even for a large-diameter substrate 4 having a diameter of 300 mm without increasing the size of the plasma source (plasma generation unit 10), the plasma generation unit 10 is arranged to be inclined with respect to the substrate 4 and a mechanism capable of rotating the substrate 4 is provided.

Here, the details of the structure of the plasma film forming apparatus 1 shown in FIG. 1 will be described. The plasma film forming apparatus 1 includes a substrate holder (substrate supporting unit) 3 which supports the substrate 4 in the vacuum chamber 2 and is provided so as to be rotatable along a film forming surface 4a of the substrate 4 and a rotating shaft 5 connected to the substrate holder 3. The substrate holder 3 has a holding portion 3a that holds the substrate 4 and a connecting portion 3b connected to the rotating shaft 5. The substrate 4 is merely placed on the holding portion 3a of the substrate holder 3 and is not sucked or the like. At that time, the substrate 4 is placed on the holding portion 3a with the film forming surface 4a facing the target 13.

Note that the substrate 4 is placed on the substrate holder 3 and taken out from the substrate holder 3 along the horizontal direction of the substrate holder 3 through the space between the holding portion 3a and the connecting portion 3b.

Further, the plasma film forming apparatus 1 includes the plasma generation unit 10 which is configured to communicate with the vacuum chamber 2 and generate the plasma 6 and is provided such that an irradiation angle θ of the plasma 6 with respect to the rotating shaft 5 forms an acute angle. Namely, the plasma generation unit 10 is not arranged directly below the substrate 4, but is arranged to be inclined with respect to the film forming surface 4a of the substrate 4. Consequently, the plasma 6 generated in the plasma generation unit 10 is irradiated from obliquely below to the film forming surface 4a of the substrate 4. At this time, the irradiation range of the plasma 6 irradiated from obliquely below is widened, and the plasma 6 can be irradiated over the entire film forming surface 4a of the substrate 4. Further, since the substrate holder 3 and the rotating shaft 5 are connected (coupled) such that a substrate mounting surface of the substrate holder 3 and the rotating shaft 5 form a substantially right angle, the irradiation angle θ of the plasma 6 irradiated from obliquely below to the film forming surface 4a of the substrate 4 with respect to the rotating shaft 5 forms an acute angle (0 < θ < 90°).

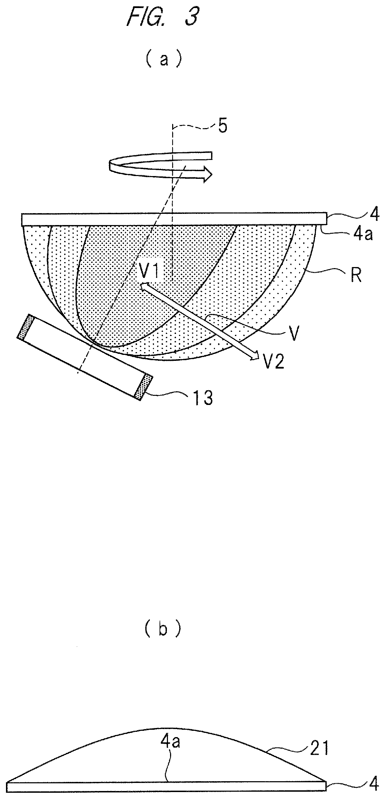

As described above, in the plasma film forming apparatus 1, the plasma generation unit 10 is arranged to be inclined with respect to the film forming surface 4a of the substrate 4. Namely, as shown in FIG. 2, the target 13 is also arranged to be inclined with respect to the film forming surface 4a of the substrate 4. Since the size of the target 13 is also limited, the irradiation range of the plasma 6 is widened by arranging the target 13 to be inclined with respect to the film forming surface 4a of the substrate 4, and the plasma 6 is irradiated over the entire surface even in the case of the large substrate 4. As a result, a film 21 (see FIG. 3) formed on the substrate 4 can be made uniform.

Further, the plasma film forming apparatus 1 includes a first driving unit 7 that moves the substrate holder 3 in the vertical direction (first direction, Z direction) 11 parallel to the rotating shaft 5, a second driving unit 8 that moves the substrate holder 3 in the horizontal direction (second direction, X direction) 12 orthogonal to the rotating shaft 5, and a third driving unit 9 that rotates the rotating shaft 5. The first driving unit 7 is a motor for moving up and down the substrate, the second driving unit 8 is a motor for horizontally moving the substrate, and the third driving unit 9 is a motor for rotating the substrate.

Therefore, in the plasma film forming apparatus 1, the substrate holder 3 is moved independently in the vertical direction 11 and the horizontal direction 12, respectively. Namely, in the plasma film forming apparatus 1, the substrate holder 3 on which the substrate 4 is placed can be moved independently in the vertical direction 11 and the horizontal direction 12, respectively.

Further, the plasma film forming apparatus 1 includes, on the vacuum chamber 2, a first operating shaft 7a which is engaged with the first driving unit 7 and is provided in parallel to the vertical direction 11 and a second operating shaft 8a which is engaged with the second driving unit 8 and is provided in parallel to the horizontal direction 12. The first operating shaft 7a and the second operating shaft 8a are, for example, ball screws. Further, an auxiliary operating shaft 7b which is another ball screw is provided in parallel to the first operating shaft 7a. The first operating shaft 7a and the auxiliary operating shaft 7b can move in synchronization with each other via a synchronization belt 7d. In addition, an auxiliary operating shaft 8b which is another ball screw is provided in parallel to the second operating shaft 8a. The second operating shaft 8a and the auxiliary operating shaft 8b can move in synchronization with each other via a synchronization belt 8d.

Further, a movable base plate 7c provided along the horizontal direction 12 is engaged with the first operating shaft 7a. The first driving unit 7 is provided on a fixed plate 7f attached to the movable base plate 7c. The movable base plate 7c is also engaged with a guide pole 7e installed in parallel to the first operating shaft 7a, and is arranged so as to be able to move up and down. The movable base plate 7c is also engaged with the auxiliary operating shaft 7b and another guide pole 7e provided in parallel to the auxiliary operating shaft 7b on the side of the auxiliary operating shaft 7b.

In addition, a supporting plate 8e which is engaged with the second operating shaft 8a and the auxiliary operating shaft 8b is attached to an end of the movable base plate 7c, and the second driving unit 8 is attached to a fixed plate 8f attached to the supporting plate 8e.

Also, the second operating shaft 8a and the auxiliary operating shaft 8b are provided with a movable plate 8c which is engaged with both shafts. Further, a fixed plate 9b is attached to the movable plate 8c, and the third driving unit 9 is provided on the fixed plate 9b.

In addition, on the movable base plate 7c, an operating mechanism (horizontal movement mechanism) by the second driving unit 8 and an operating mechanism (substrate rotation mechanism) by the third driving unit 9 are provided. Specifically, a box-shaped first movable unit (movable unit) 20a is provided on the movable base plate 7c, and further, a conversion mechanism unit 18 that converts the rotation of a third operating shaft 9a provided along the horizontal direction 12 into the rotation of the rotating shaft 5 provided along the vertical direction 11 is provided inside the box-shaped first movable unit 20a. The conversion mechanism unit 18 is, for example, a bevel gear provided at each engaging portion of the third operating shaft 9a and the rotating shaft 5, and is arranged inside a box-shaped second movable unit 20b. Further, the second movable unit 20b is arranged inside the box-shaped first movable unit 20a. Namely, the first movable unit 20a also covers the conversion mechanism unit 18 via the second movable unit 20b, and is mounted on the movable base plate 7c so as to be movable in the vertical direction 11.

Note that the second operating shaft 8a is provided so as to penetrate from the outside to the inside of the box-shaped first movable unit 20a, and an upper portion of the box-shaped second movable unit 20b is engaged with the second operating shaft 8a inside the first movable unit 20a. Also, the second movable unit 20b is connected to the movable plate 8c via a connecting shaft 8g.

In the structure described above, when the first operating shaft 7a is rotated by the drive of the first driving unit 7, the auxiliary operating shaft 7b is also rotated via the synchronization belt 7d. Then, by the rotation of the first operating shaft 7a and the auxiliary operating shaft 7b, the movable base plate 7c moves up or down (moves in the Z direction) together with the first driving unit 7 provided on the fixed plate 7f while being guided by the guide poles 7e.

Further, by the upward or downward movement (movement in the Z direction) of the movable base plate 7c, the rotating shaft 5 which is a part of the mechanism (substrate rotation mechanism) operated by the drive of the third driving unit 9 moves up or down. Then, by the upward or downward movement of the rotating shaft 5, the substrate holder 3 moves up or down, and thus the substrate 4 also moves up or down. Namely, the position of the substrate 4 in the vertical direction 11 can be moved to a desired position by moving up or down the movable base plate 7c.

Further, when the second operating shaft 8a is rotated by the drive of the second driving unit 8, the auxiliary operating shaft 8b is also rotated in synchronization via the synchronization belt 8d. Then, when the second operating shaft 8a and the auxiliary operating shaft 8b are rotated, the movable plate 8c engaged with both shafts moves in the horizontal direction 12. Namely, the movable plate 8c moves in the horizontal direction 12 (moves in the X direction) by the rotation of the second operating shaft 8a and the auxiliary operating shaft 8b. Then, as the movable plate 8c moves in the horizontal direction 12, the second movable unit 20b connected to the movable plate 8c via the connecting shaft 8g moves in the horizontal direction 12 in the box-shaped first movable unit 20a while being guided by the second operating shaft 8a. Consequently, the rotating shaft 5 also moves in the horizontal direction 12. Further, by the movement of the rotating shaft 5 in the horizontal direction 12, the substrate holder 3 moves in the horizontal direction 12, so that the substrate 4 also moves in the horizontal direction 12. Namely, by the movement of the movable plate 8c in the horizontal direction 12, the position of the substrate 4 in the horizontal direction 12 can be moved to a desired position.

Also, the third operating shaft 9a provided along the horizontal direction 12 is rotated by the drive of the third driving unit 9, and further, the rotation of the third operating shaft 9a is converted into the rotation of the rotating shaft 5 provided along the vertical direction 11 by the conversion mechanism unit 18 composed of bevel gears. Then, the substrate holder 3 is rotated by the rotation of the rotating shaft 5, so that the substrate 4 is also rotated along the horizontal direction 12. Namely, the substrate 4 can be rotated in the horizontal direction 12 by the rotation of the third operating shaft 9a. Note that, in the plasma film forming apparatus 1, the rotation of the substrate 4 along the horizontal direction 12 is performed in the film forming process.

Also, the plasma film forming apparatus 1 includes a first bellows unit 19a which is attached to the movable base plate 7c so as to communicate the first movable unit 20a and the vacuum chamber 2, surrounds a part of the rotating shaft 5, and keeps the inside of the vacuum chamber 2 in a vacuum atmosphere. Since the first bellows unit 19a has a bellows structure and can be expanded and contracted, it follows the movement of the movable base plate 7c in the vertical direction 11. Accordingly, even if the movable base plate 7c moves in the vertical direction 11, the vacuum atmosphere of the first movable unit 20a and the vacuum chamber 2 is maintained by the first bellows unit 19a.

Further, in the plasma film forming apparatus 1, a second bellows unit 19b which communicates with the vacuum chamber 2 via the first bellows unit 19a and the first movable unit 20a and surrounds a part of each of the third operating shaft 9a and the connecting shaft 8g is attached to the movable plate 8c. Since the second bellows unit 19b also has a bellows structure and can be expanded and contracted, it follows the movement of the movable plate 8c in the horizontal direction 12. Accordingly, even if the movable plate 8c moves in the horizontal direction 12, the vacuum atmosphere of the first movable unit 20a and the vacuum chamber 2 is maintained by the second bellows unit 19b.

In the plasma film forming apparatus 1 according to the present embodiment, the substrate 4 can be moved independently in the vertical direction 11 and the horizontal direction 12 in the vacuum chamber 2. Namely, the position of the substrate holder 3 can be moved independently in the vertical direction 11 and the horizontal direction 12, respectively. At the time of the film forming process by sputtering, only the rotation of the substrate 4 is performed, and the movement in the vertical direction 11 or the horizontal direction 12 is performed before the film forming process is started.

From the foregoing, it can be said that the plasma film forming apparatus 1 according to the present embodiment has a function capable of maintaining the uniformity of the film thickness of the film 21 formed on the substrate 4 even if the target 13 is worn or the conditions of film forming process are different.

Here, the concept of position adjustment of the substrate 4 in the plasma film forming apparatus 1 will be described with reference to FIG. 2. As shown in FIG. 2, the distance between the target 13 and the center of the film forming surface 4a of the substrate 4 is defined as T-S, and the shift amount between the center of the target 13 and the center of the film forming surface 4a of the substrate 4 is defined as Xs. The plasma film forming apparatus 1 includes a mechanism that can move the substrate 4 in the vertical direction 11 (Z direction) (vertical movement mechanism) and a mechanism that can move the substrate 4 in the horizontal direction 12 (X direction) (horizontal movement mechanism). For example, it is possible to change only T-S while fixing Xs, and conversely, change only Xs while fixing T-S.

Next, in the plasma film forming apparatus 1 according to the present embodiment, the distribution state of the particles sputtered from the target 13 will be described. FIGs. 3 (a) and 3(b), FIGs. 4(a) and 4(b), and FIGs. 5(a) and 5 (b) are conceptual diagrams of particle distribution at the time of sputtering in the plasma film forming apparatus shown in FIG. 1 and conceptual diagrams showing a shape of the film formed on the substrate. Note that the R part in each of FIGs. 3(a), 4(a), and 5(a) shows the distribution state of the sputtered particles, and the higher dot density in each R part indicates the larger distribution amount of the sputtered particles.

FIG. 3(a) shows the distribution amount of particles at the time of sputtering in the case where the center of the substrate 4 and the center of the target 13 substantially match with each other, and shows that the film forming rate is higher on the V1 side (high dot density) of the arrow V and the film forming rate is lower on the V2 side (low dot density) of the arrow V. Also, at the time of film formation, the substrate 4 is being rotated. In this case, as shown in FIG. 3(b), since the film forming rate is high near the center of the substrate 4, the amount of the film 21 to be formed is large and the distribution of film thickness has a convex shape.

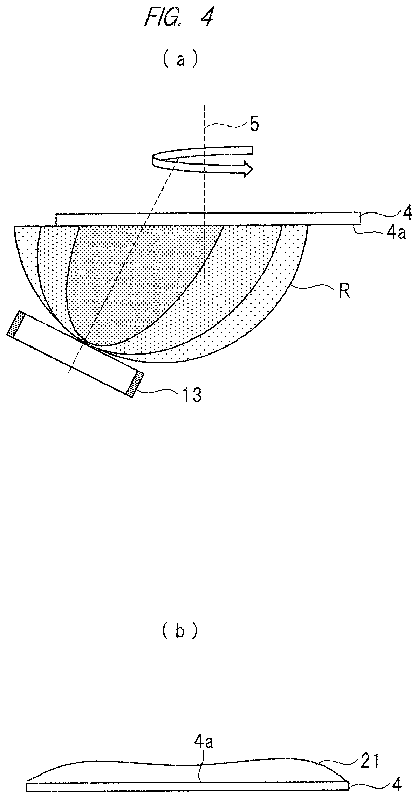

FIG. 4(a) shows the distribution amount of particles at the time of sputtering in the case where the center of the substrate 4 is shifted to the right (horizontal direction away from the target 13) of the drawing. In this case, as shown in FIG. 4(b), since the film forming rate is higher near the outer peripheral portion of the substrate 4, the amount of the film 21 to be formed is larger near the outer peripheral portion. However, although the amount of film formed near the center is small, the film thickness is made uniform because the substrate 4 is being rotated.

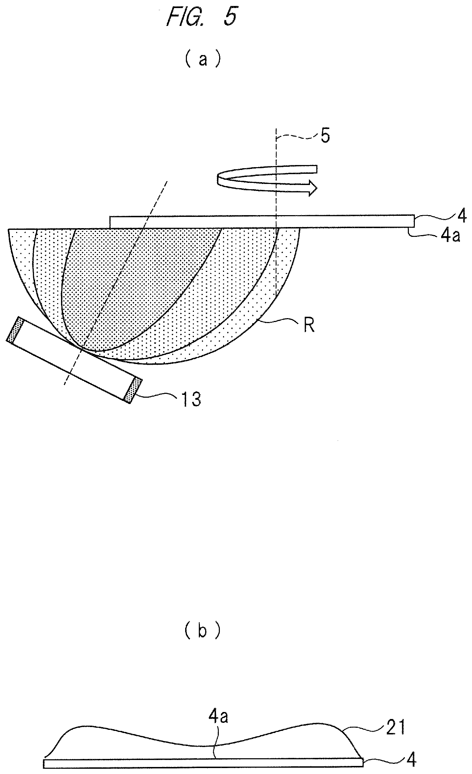

FIG. 5(a) shows the distribution amount of particles at the time of sputtering in the case where the center of the substrate 4 is further shifted to the right (horizontal direction further away from the target 13) of the drawing. In this case, as shown in FIG. 5(b), since the film forming rate is still higher near the outer peripheral portion of the substrate 4, the amount of the film 21 to be formed is still larger near the outer peripheral portion. In addition, since the amount of film formed near the center is still smaller, the distribution of film thickness has a concave shape with a recess at its center because the substrate 4 is being rotated.

Therefore, in the plasma film forming apparatus 1 according to the present embodiment, it is preferable that the distribution of film thickness has the shape shown in FIG. 4(b). Thus, in the plasma film forming apparatus 1, as shown in FIG. 2, the center of the film forming surface 4a of the substrate 4 and the center of the target 13 are shifted by the length of Xs (shift amount). Namely, the center of plasma irradiation is set at the position shifted from the center of the substrate 4, and the substrate 4 is rotated in the film forming process. As a result, the distribution of film thickness of the film 21 formed on the substrate 4 at the time of film formation has a convex shape near the outer peripheral portion, and the convex portion near the outer peripheral portion is added and the distribution is further averaged because of the rotation of the substrate 4. In this manner, the plasma film forming apparatus 1 can make the film thickness uniform.

As described above, in the plasma film forming apparatus 1, the sizes of Xs and T-S affect the uniformity of the film thickness. Also, the position of the substrate 4 in the vertical direction 11 or the horizontal direction 12 is adjusted before performing the film forming process such that the distribution of film thickness has the shape shown in FIG. 4 (b) . At that time, in the plasma film forming apparatus 1, each parameter in the vertical direction 11 and the horizontal direction 12 can be moved by, for example, each 1 mm. Consequently, the film forming position on the substrate 4 can be freely changed.

In the plasma film forming apparatus 1 according to the present embodiment, the mechanisms capable of independently moving the substrate 4 in the vertical direction 11 and the horizontal direction 12 are provided, and thus the control range of the film thickness of the film 21 formed on the substrate 4 can be widened. Further, the position of the substrate 4 can be flexibly moved, and the film thickness of the film 21 formed on the substrate 4 can be made uniform. For example, high film thickness uniformity can be obtained even for the large-diameter substrate 4 having a diameter of 300 mm. In addition, a high quality thin film can be formed.

Next, the plasma film forming method according to the present embodiment will be described. In the plasma film forming method according to the present embodiment, a film forming process by sputtering is performed using the plasma film forming apparatus 1 shown in FIG. 1.

First, the substrate 4 is conveyed into the vacuum chamber 2 of the plasma film forming apparatus 1 shown in FIG. 1, and the substrate 4 is placed on the rotatable substrate holder 3 provided in the vacuum chamber 2. At that time, the substrate 4 is inserted through the space between the holding portion 3a and the connecting portion 3b of the substrate holder 3, and the substrate 4 is placed on the holding portion 3a such that the film forming surface 4a of the substrate 4 faces downward (the film forming surface 4a of the substrate 4 faces the target 13). In this manner, the substrate 4 is supported by the substrate holder 3. As the sputter material provided on the target 13, for example, any solid material such as aluminum, silicon, and tantalum can be used.

After the substrate is placed, in the state where the substrate holder 3 is being rotated along the horizontal direction 12 by the third driving unit 9 in the vacuum chamber 2, the film is formed on the substrate 4 by irradiating the plasma 6 onto the substrate 4 from the plasma generation unit 10 such that the irradiation angle θ of the plasma 6 with respect to the rotating shaft 5 of the substrate holder 3 forms an acute angle.

Specifically, the plasma 6 is formed by generating ECR by the electric field of the microwave 16 and the magnetic field formed by the coil 15 provided around the plasma generation unit 10. At the same time, the electrons in the plasma move into the vacuum chamber 2 along the magnetic field gradient generated by the coil 15.

In doing so, the ions are also drawn into the vacuum chamber 2 so as to be dragged by the potential formed by the electrons. At this time, by applying the RF power 14 to the target 13 to cause the ions in the plasma to collide with the target 13, the film is formed on the substrate 4 by the sputtering action. Also, when forming the film, process gas 17 is introduced from a gas introduction port 2a of the vacuum chamber 2.

Further, the plasma film forming apparatus 1 includes the plasma generation unit 10 provided such that the irradiation angle θ of the plasma 6 with respect to the rotating shaft 5 of the substrate 4 forms an acute angle. Namely, the plasma generation unit 10 is arranged to be inclined with respect to the film forming surface 4a of the substrate 4. Consequently, the plasma 6 generated in the plasma generation unit 10 is irradiated from obliquely below to the film forming surface 4a of the substrate 4. At this time, the irradiation range of the plasma 6 irradiated from obliquely below is widened, and the plasma 6 is irradiated over the entire film forming surface 4a of the substrate 4.

As a result, the desired film 21 is formed on the film forming surface 4a of the substrate 4 by sputtering.

After forming the film, the substrate 4 is taken out from the vacuum chamber 2 and the distribution of film thickness of the film 21 formed on the substrate 4 is measured. When the substrate 4 is taken out from the substrate holder 3, the substrate 4 is taken out through the space between the holding portion 3a and the connecting portion 3b, and the substrate 4 is further conveyed to the outside of the vacuum chamber 2.

Then, after the substrate 4 is taken out from the vacuum chamber 2, the distribution of film thickness of the film 21 formed on the substrate 4 is measured. Next, after measuring the distribution of film thickness, the substrate holder 3 is moved in the horizontal direction 12 orthogonal to the vertical direction 11 parallel to the rotating shaft 5 or the vertical direction 11 and the horizontal direction 12 based on the measurement result of the distribution of film thickness. Namely, the position of the substrate 4 is adjusted such that the distribution of film thickness on the substrate 4 has the shape shown in FIG. 4(b).

In the present embodiment, as an example, the substrate holder 3 is moved in the horizontal direction 12. Namely, only the shift amount Xs between the center of the target 13 and the center of the film forming surface 4a of the substrate 4 is adjusted without changing the distance T-S between the target 13 and the center of the film forming surface 4a of the substrate 4.

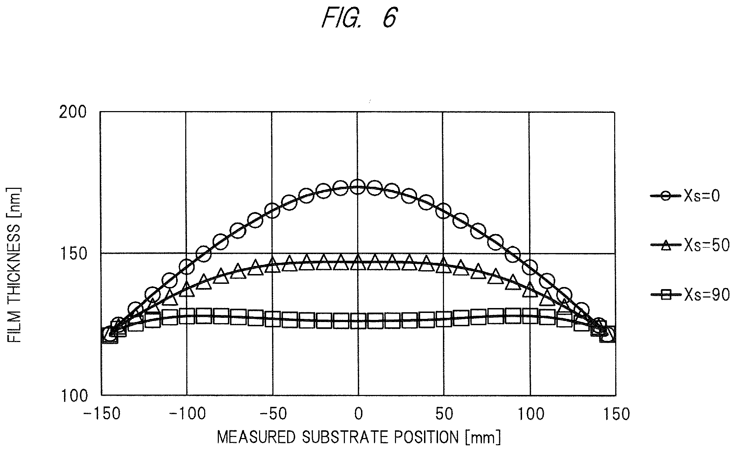

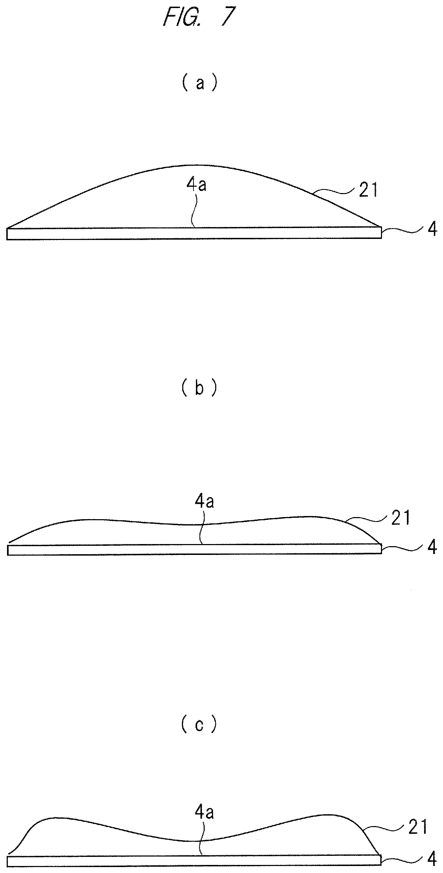

Here, FIG. 6 is a film thickness distribution diagram showing the distribution of film thickness on a substrate on which a film is formed using the plasma film forming apparatus shown in FIG. 1, FIG. 7 (a) is a schematic diagram showing the distribution of film thickness on a substrate based on the measured value of FIG. 6 in the case of Xs = 0 mm, FIG. 7 (b) is a schematic diagram showing the distribution of film thickness on a substrate based on the measured value of FIG. 6 in the case of Xs = 90 mm, and FIG. 7 (c) is a schematic diagram showing the distribution of film thickness on a substrate based on the measured value of FIG. 6 in the case of Xs > 90 mm. Note that both FIG. 6 and FIG. 7 show the results of measurements or simulations in which the value of T-S is fixed at 295 mm (T-S = 295 mm). Also, the film thickness uniformity in the distribution of film thickness of FIG. 7(a) is ±17.5%, and the film thickness uniformity in the distribution of film thickness of FIG. 7(b) is ±2.9%.

As a result of measuring the distribution of film thickness of the film 21 formed on the substrate 4 by the film forming process, when the distribution of film thickness is close to the shape of Xs = 0 mm in FIG. 6, that is, the distribution of film thickness has a convex shape (in the case of FIG. 7(a)), the shift amount Xs between the center of the target 13 and the center of the substrate 4 is changed while fixing the distance T-S between the target 13 and the center of the film forming surface 4a of the substrate 4 at 295 mm (without changing the distance T-S). Namely, by feeding back the measurement result of the distribution of film thickness of the film 21 formed on the substrate 4, only the shift amount Xs is changed to adjust the position of the substrate 4 while fixing the distance T-S at 295 mm. In this case, the substrate holder 3 is moved such that the shift amount Xs becomes larger than the shift amount Xs at the time of film formation for measurement. For example, the value of the shift amount Xs is adjusted to 90 mm (Xs = 90 mm) in FIG. 6 (FIG. 7(b)). Actually, the moving distance X1 in the horizontal direction 12 to be input to the plasma film forming apparatus 1 is calculated from the shift amount Xs to be adjusted, and this X1 value is input.

In the plasma film forming apparatus 1 according to the present embodiment, the position of the substrate holder 3 can be moved independently in the vertical direction 11 and the horizontal direction 12, respectively. Therefore, it is possible to adjust the position of the substrate holder 3 (substrate 4) by moving it only in the horizontal direction 12.

After the substrate 4 is placed on the substrate holder 3 in the vacuum chamber 2 and the position of the substrate holder 3 is adjusted using the X1 value above, in the state where the substrate holder 3 is being rotated by the third driving unit 9, the film is formed again on the substrate 4 by irradiating the plasma 6 onto the substrate 4 from the plasma generation unit 10 such that the irradiation angle θ of the plasma 6 with respect to the rotating shaft 5 of the substrate holder 3 forms an acute angle.

As a result, as shown in FIG. 7(b), the film thickness of the film 21 formed on the substrate 4 can be made uniform.

Next, the case where the distribution of film thickness is close to the shape of Xs > 90 mm in FIG. 6 as a result of measuring the distribution of film thickness of the film 21 formed on the substrate 4, that is, the center of the distribution of film thickness has a concave shape (the case of FIG. 7(c)) will be described.

When the center of the distribution of film thickness of the film 21 formed on the substrate 4 has a concave shape, the shift amount Xs between the center of the target 13 and the center of the substrate 4 is changed while fixing the distance T-S between the target 13 and the center of the film forming surface 4a of the substrate 4 at 295 mm (without changing the distance T-S). In this case, the substrate holder 3 is moved such that the shift amount Xs becomes smaller than the shift amount Xs at the time of film formation for measurement. For example, the value of the shift amount Xs is adjusted to 90 mm in FIG. 6 (Xs = 90 mm) (FIG. 7(b)). Actually, the moving distance X2 in the horizontal direction 12 to be input to the plasma film forming apparatus 1 is calculated from the shift amount Xs to be adjusted, and this X2 value is input.

Since the plasma film forming apparatus 1 according to the present embodiment can move the position of the substrate holder 3 independently in the vertical direction 11 and the horizontal direction 12, it is possible to adjust the position of the substrate holder 3 (substrate 4) by moving it only in the horizontal direction 12.

After the substrate 4 is placed on the substrate holder 3 in the vacuum chamber 2 and the position of the substrate holder 3 is adjusted using the X2 value mentioned above, in the state where the substrate holder 3 is being rotated by the third driving unit 9, the film is formed again on the substrate 4 by irradiating the plasma 6 onto the substrate 4 from the plasma generation unit 10 such that the irradiation angle θ of the plasma 6 with respect to the rotating shaft 5 of the substrate holder 3 forms an acute angle.

As a result, as shown in FIG. 7(b), the film thickness of the film 21 formed on the substrate 4 can be made uniform.

In the plasma film forming method above, the case where only the shift amount Xs is adjusted to move the substrate 4 in the horizontal direction 12 while fixing the distance T-S has been described, but the film may be formed again by adjusting only the distance T-S to move the substrate 4 in the vertical direction 11 while fixing the shift amount Xs. Alternatively, the film may be formed again by adjusting both the distance T-S and the shift amount Xs to move the substrate 4 independently in the vertical direction 11 and the horizontal direction 12.

In the plasma film forming method according to the present embodiment, after a film is formed once and the distribution of film thickness thereof is measured, the position of the substrate 4 is adjusted by moving the substrate holder 3 based on the measurement result in the horizontal direction 12 orthogonal to the rotating shaft 5 of the substrate holder 3 or both the vertical direction 11 and the horizontal direction 12, and the plasma 6 is irradiated to the substrate 4 to form the film again on the substrate 4 in this state.

Namely, by forming the film again after the position of the substrate 4 is adjusted to the position close to the position of the substrate 4 where the distribution of film thickness can be made uniform, obtained in advance by the simulation or the actual measurement, the control range of the film thickness of the film 21 formed on the substrate 4 can be widened, and the film thickness can be made uniform even in the case of the large-diameter substrate 4 without increasing the size of the plasma film forming apparatus 1. Also, it is possible to form a high-quality thin film.

Further, by irradiating the plasma 6 over the entire film forming surface 4a of the substrate 4, the film 21 formed on the substrate 4 can be made to have a uniform thickness without being in a laminated state.

In the plasma film forming apparatus 1 according to the present embodiment, the plasma 6 can be obliquely irradiated to the substrate 4, and further the position of the substrate 4 can be adjusted not only in the vertical direction 11 but also in the horizontal direction 12. Originally, in a plasma film forming apparatus, moving the substrate 4 in the horizontal direction 12 is mechanically difficult as compared with moving the substrate 4 in the vertical direction 11, and a moving mechanism in the horizontal direction 12 is not provided if there is no need. However, the inventors have found the necessity of moving the substrate 4 in the horizontal direction 12 when performing the film forming process on the large-diameter substrate 4 having a diameter of 300 mm.

Namely, it is conceivable to irradiate the plasma 6 by simply shifting the substrate 4 in the vertical direction 11 and the horizontal direction 12, but when trying to adapt the plasma film forming apparatus to the large-diameter substrate 4, the amount of movement of the substrate 4 in the horizontal direction 12 needs to be increased, so that the size of the plasma film forming apparatus is increased. Further, there appears the region in which the plasma 6 is not irradiated, in the large-diameter substrate 4. If the state in which the plasma 6 is not irradiated and the state in which the plasma 6 is irradiated occur on the substrate 4, there is the possibility that the formed films 21 may be laminated (an interface may be formed in the film 21).

Therefore, as in the plasma film forming apparatus 1 according to the present embodiment, by irradiating the plasma 6 from obliquely below the substrate 4, the irradiation range of the plasma 6 can be widened as described above, and the plasma 6 can be irradiated over the entire film forming surface 4a of the substrate 4. As a result, the film 21 formed on the substrate 4 can be made to have a uniform thickness without being in a laminated state.

If the plasma 6 is vertically irradiated from directly below the substrate 4 instead of oblique irradiation, it is not necessary to provide a moving mechanism of the substrate 4 in the horizontal direction 12, but the film formation range is narrowed in that case. Therefore, in the film forming process on the large-diameter substrate 4 having a diameter of 300 mm, it is important to irradiate the plasma 6 from obliquely below the substrate 4 as in the plasma film forming apparatus 1 according to the present embodiment. In addition, in the plasma film forming apparatus 1 according to the present embodiment, the substrate 4 can be moved independently in the vertical direction 11 and the horizontal direction 12, and thus the control range of the film thickness of the film 21 formed on the substrate 4 can be widened as described above, and the position control range of the substrate 4 can be adapted to the large-diameter substrate 4 without increasing the size of the plasma film forming apparatus 1. Further, the film thickness can be made uniform even in the case of the large-diameter substrate 4.

In the foregoing, the invention made by the inventors has been specifically described based on the embodiment, but the present invention is not limited to the embodiment described above and includes various modifications. For example, the embodiment above has been described in detail in order to make the present invention easily understood, and the present invention is not necessarily limited to the embodiment having all of the described configurations.

In the above-described embodiment, as a plasma film forming method, the case where, after a film forming process is first performed and the distribution of film thickness is measured, the position of the substrate 4 is adjusted by moving the substrate 4 in the horizontal direction 12 or both the vertical direction 11 and the horizontal direction 12 based on the measurement result, and then the film forming process is performed again has been described. As the above-described plasma film forming method, the data of the distribution of film thickness may be measured again at the time when the film forming process is performed on the substrate 4 multiple times after adjusting the position of the substrate 4 based on the measurement result of the distribution of film thickness, and the position of the substrate 4 may be adjusted again by moving it in the horizontal direction 12 or both the vertical direction 11 and the horizontal direction 12 based on this measurement result.

For example, when the film forming process is performed multiple times, the target material gradually decreases and the distribution of film thickness of the film 21 formed on the substrate 4 also changes at that time, and it is thus necessary to adjust the height of the substrate 4 again. At this time, if the height (position in the vertical direction 11) of the substrate 4 is changed to increase the distance T-S between the target 13 and the center of the film forming surface 4a of the substrate 4, the film forming rate changes. However, in the plasma film forming apparatus 1 according to the above-described embodiment, since the substrate 4 can be moved in the horizontal direction 12, the film thickness can be made uniform and the above-mentioned rate does not change, and the film quality can be maintained at the same level.

### REFERENCE SIGNS LIST

1: plasma film forming apparatus
2: vacuum chamber (vacuum container)
2a: gas introduction port
3: substrate holder (substrate supporting unit)
3a: holding portion
3b: connecting portion
4: substrate
4a: film forming surface
5: rotating shaft
6: plasma
7: first driving unit
7a: first operating shaft
7b: auxiliary operating shaft
7c: movable base plate
7d: synchronization belt
7e: guide pole
7f: fixed plate
8: second driving unit
8a: second operating shaft
8b: auxiliary operating shaft
8c: movable plate
8d: synchronization belt
8e: supporting plate
8f: fixed plate
8g: connecting shaft
9: third driving unit
9a: third operating shaft
9b: fixed plate
10: plasma generation unit
11: vertical direction (first direction)
12: horizontal direction (second direction)
13: target
14: RF power
15: coil
16: microwave
17: process gas
18: conversion mechanism unit
19a: first bellows unit
19b: second bellows unit
20a: first movable unit (movable unit)
20b: second movable unit
21: film

## Claims

1. A plasma film forming apparatus (1) for performing a film forming process by
irradiating a plasma (6), the apparatus comprising:
a vacuum container in which the film forming process is performed to a substrate (4);
a substrate supporting unit configured to support the substrate (4) in the vacuum container and provided so as to be rotatable along a film forming surface (4a) of the substrate (4);
a rotating shaft (5) connected to the substrate supporting unit;
a plasma generation unit (10) communicating with the vacuum container, configured to generate the plasma (6), and provided such that an irradiation angle of the plasma (6) with respect to the rotating shaft (5) forms an acute angle;
a first driving unit (7) configured to move the substrate supporting unit in a first direction parallel to the rotating shaft (5);
a second driving unit (8) configured to move the substrate supporting unit in a second direction orthogonal to the rotating shaft (5);
a third driving unit (9) configured to rotate the rotating shaft (5);
wherein the substrate supporting unit is configured to be moved independently in the first direction and the second direction;
**characterized in that** the plasma film forming apparatus further includes
a first operating shaft (7a) rotated by a drive of the first driving unit (7); and
a second operating shaft (8a) orthogonal to the first operating shaft (7a) and rotated by a drive of the second driving unit (8),
wherein the drive of the first driving unit (7) is configured to rotate the first operating shaft (7a) so as to move the substrate supporting unit in the first direction, and wherein the drive of the second driving unit (8) is configured to rotate the second operating shaft (8a) so as to move the substrate supporting unit in the second direction.

2. The plasma film forming apparatus (1) according to claim 1, further comprising:
a motor for substrate vertical movement provided as the first driving unit (7) ; and
a motor for substrate horizontal movement provided as the second driving unit (8),
wherein the drive of the motor for substrate vertical movement is configured to rotate the first operating shaft (7a) so as to operate the rotating shaft (5) in the first direction and so as to move the substrate supporting unit in the first direction, and wherein the drive of the motor for substrate horizontal movement is configured to rotate the second operating shaft (8a) so as to operate the rotating shaft (5) in the second direction and so as to move the substrate supporting unit in the second direction.

3. The plasma film forming apparatus (1) according to claim 2, further comprising:
a motor for substrate rotation provided as the third driving unit (9);
a third operating shaft (9a) orthogonal to the first operating shaft (7a) and rotated by a drive of the motor for substrate rotation;
a conversion mechanism unit (18) configured to convert a rotation of the third operating shaft (9a) into a rotation of the rotating shaft (5); and
a first bellows unit (19a) configured to cover the conversion mechanism unit (18) so as to communicate a movable unit moving along the first direction and the vacuum container, surround a part of the rotating shaft (5), and keep an inside of the vacuum container in a vacuum atmosphere.

4. The plasma film forming apparatus (1) according to claim 3, further comprising a second bellows unit (19b) configured to communicate with the vacuum container via the first bellows unit (19a) and the movable unit and surround a part of the third operating shaft (9a).

5. A plasma film forming method for performing a film forming process by irradiating a plasma (6), comprising the steps of:
(a) supporting a substrate (4) by a rotatable substrate supporting unit provided in a vacuum container;
(b) after the step (a), in a state where the substrate supporting unit is being rotated by a drive of a motor for substrate rotation, forming a film (21) on the substrate (4) by irradiating the plasma (6) to the substrate (4) such that an irradiation angle of the plasma (6) with respect to a rotating shaft (5) of the substrate supporting unit forms an acute angle;
**characterized by**
(c) after the step (b), taking out the substrate (4) from the vacuum container and measuring a distribution of film thickness of the film (21) formed on the substrate (4);
(d) after the step (c), based on a measurement result of the distribution of film thickness, moving the substrate supporting unit in a second direction orthogonal to a first direction parallel to the rotating shaft (5) or the first direction and the second direction;
(e) after the step (d), in a state where the substrate supporting unit is being rotated by the drive of the motor for substrate rotation, forming a film (21) on the substrate (4) by irradiating the plasma (6) to the substrate (4) such that an irradiation angle of the plasma (6) with respect to the rotating shaft (5) of the substrate supporting unit forms an acute angle,
wherein, in the step (d), the substrate supporting unit moves in the first direction by causing a first operating shaft (7a) to rotate by a drive of a motor for substrate vertical movement and moves in the second direction by causing a second operating shaft (8a) orthogonal to the first operating shaft (7a) to rotate by a drive of a motor for substrate horizontal movement, so that the substrate supporting unit can move independently in the first direction and the second direction.

6. The plasma film forming method according to claim 5,
wherein, in the step (d), either of a distance between a target (13) and a center of a film forming surface (4a) of the substrate (4) or a shift amount between a center of the target (13) and the center of the film forming surface (4a) of the substrate (4) is adjusted by moving the substrate supporting unit in the second direction or the first direction and the second direction.

7. The plasma film forming method according to claim 6,
wherein, in the step (d), without changing the distance between the target (13) and the center of the film forming surface (4a) of the substrate (4), the substrate supporting unit is moved such that the shift amount between the center of the target (13) and the center of the substrate (4) becomes larger or smaller than the shift amount at the time of the film formation in the step (b).

8. The plasma film forming method according to claim 5,
wherein, in the step (b) and the step (e), the plasma (6) is irradiated over the entire film forming surface (4a) of the substrate (4).

## Patentansprüche

1. Plasmafilmbildungsvorrichtung (1) zum Durchführen eines Filmbildungsprozesses durch Einstrahlen eines Plasmas (6), wobei die Vorrichtung umfasst:
einen Vakuumbehälter, in dem der Filmbildungsprozess an einem Substrat (4) durchgeführt wird,
eine Substratstützeinheit, die derart ausgelegt ist, dass sie das Substrat (4) im Vakuumbehälter stützt, und derart bereitgestellt ist, dass sie entlang einer Filmbildungsfläche (4a) des Substrats (4) drehbar ist,
eine Drehwelle (5), die mit der Substratstützeinheit verbunden ist,
eine mit dem Vakuumbehälter kommunizierende Plasmaerzeugungseinheit (10), die zum Erzeugen des Plasmas (6) ausgelegt ist und derart bereitgestellt ist, dass ein Einstrahlwinkel des Plasmas (6) in Bezug auf die Drehwelle (5) einen spitzen Winkel bildet,
eine erste Antriebseinheit (7), die derart ausgelegt ist, dass sie die Substratstützeinheit in eine erste Richtung parallel zur Drehwelle (5) bewegt,
eine zweite Antriebseinheit (8), die derart ausgelegt ist, dass sie die Substratstützeinheit in eine zweite Richtung orthogonal zur Drehwelle (5) bewegt,
eine dritte Antriebseinheit (9), die derart ausgelegt ist, dass sie die Drehwelle (5) dreht,
wobei die Substratstützeinheit derart ausgelegt ist, dass sie unabhängig in die erste Richtung und die zweite Richtung bewegt wird,
**dadurch gekennzeichnet, dass** die Plasmafilmbildungsvorrichtung ferner umfasst:
eine erste Betätigungswelle (7a), die durch einen Antrieb der ersten Antriebseinheit (7) gedreht wird, und
eine zweite Betätigungswelle (8a), die orthogonal zur ersten Betätigungswelle (7a) ist und durch einen Antrieb der zweiten Antriebseinheit (8) gedreht wird,
wobei der Antrieb der ersten Antriebseinheit (7) derart ausgelegt ist, dass er die erste Betätigungswelle (7a) dreht, um die Substratstützeinheit in die erste Richtung zu bewegen, und wobei der Antrieb der zweiten Antriebseinheit (8) derart ausgelegt ist, dass er die zweite Betätigungswelle (8a) dreht, um die Substratstützeinheit in die zweite Richtung zu bewegen.

2. Plasmafilmbildungsvorrichtung (1) nach Anspruch 1, ferner umfassend:
einen Motor für eine vertikale Substratbewegung, der als die erste Antriebseinheit (7) bereitgestellt ist, und
einen Motor für eine horizontale Substratbewegung, der als die zweite Antriebseinheit (8) bereitgestellt ist,
wobei der Antrieb des Motors für eine vertikale Substratbewegung derart ausgelegt ist, dass er die erste Betätigungswelle (7a) dreht, um die Drehwelle (5) in die erste Richtung zu betätigen und um und die Substratstützeinheit in die erste Richtung zu bewegen, und wobei der Antrieb des Motors für eine horizontale Substratbewegung derart ausgelegt ist, dass er die zweite Betätigungswelle (8a) dreht, um die Drehwelle (5) in die zweite Richtung zu betätigen und um die Substratstützeinheit in die zweite Richtung zu bewegen.

3. Plasmafilmbildungsvorrichtung (1) nach Anspruch 2, ferner umfassend:
einen Motor für eine Substratdrehung, der als die dritte Antriebseinheit (9) bereitgestellt ist,
eine dritte Betätigungswelle (9a), die orthogonal zur ersten Betätigungswelle (7a) ist und durch einen Antrieb des Motors für eine Substratdrehung gedreht wird,
eine Umwandlungsmechanismuseinheit (18), die derart ausgelegt ist, dass sie eine Drehung der dritten Betätigungswelle (9a) in eine Drehung der Drehwelle (5) umwandelt, und
eine erste Balgeinheit (19a), die derart ausgelegt ist, dass sie die Umwandlungsmechanismuseinheit (18) abdeckt, um eine bewegliche Einheit, die sich entlang der ersten Richtung bewegt, mit dem Vakuumbehälter zu kommunizieren, einen Teil der Drehwelle (5) zu umgeben, und ein Inneres des Vakuumbehälters in einer Vakuumatmosphäre zu halten.

4. Plasmafilmbildungsvorrichtung (1) nach Anspruch 3, die ferner eine zweite Balgeinheit (19b) umfasst, die derart ausgelegt ist, dass sie über die erste Balgeinheit (19a) und die bewegliche Einheit mit dem Vakuumbehälter kommuniziert und einen Teil der dritten Betätigungswelle (9a) umgibt.

5. Plasmafilmbildungsverfahren zum Durchführen eines Filmbildungsprozesses durch Einstrahlen eines Plasmas (6), das die Schritte umfasst:
(a) Stützen eines Substrats (4) durch eine drehbare Substratstützeinheit, die in einem Vakuumbehälter bereitgestellt ist,
(b) nach Schritt (a), in einem Zustand, in dem die Substratstützeinheit durch einen Antrieb eines Motors für eine Substratdrehung gedreht wird, Ausbilden eines Films (21) auf dem Substrat (4) durch Einstrahlen des Plasmas (6) auf das Substrat (4), so dass ein Einstrahlwinkel des Plasmas (6) in Bezug auf eine Drehwelle (5) der Substratstützeinheit einen spitzen Winkel bildet,
**dadurch gekennzeichnet**,
(c) nach Schritt (b), Entnehmen des Substrats (4) aus dem Vakuumbehälter und Messen einer Verteilung einer Filmdicke des auf dem Substrat (4) ausgebildeten Films (21),
(d) nach Schritt (c), auf der Grundlage eines Messergebnisses der Filmdickenverteilung, Bewegen der Substratstützeinheit in eine zweite Richtung orthogonal zu einer ersten Richtung parallel zur Drehwelle (5) oder die erste Richtung und die zweite Richtung,
(e) nach Schritt (d), in einem Zustand, in dem die Substratstützeinheit durch den Antrieb des Motors für eine Substratdrehung gedreht wird, Ausbilden eines Films (21) auf dem Substrat (4) durch Einstrahlen des Plasmas (6) auf das Substrat (4), so dass ein Einstrahlwinkel des Plasmas (6) in Bezug auf die Drehwelle (5) der Substratstützeinheit einen spitzen Winkel bildet,
wobei sich im Schritt (d) die Substratstützeinheit in die erste Richtung bewegt, indem eine erste Betätigungswelle (7a) durch einen Antrieb eines Motors für eine vertikale Substratbewegung in Drehung versetzt wird, und sich in die zweite Richtung bewegt, indem eine zweite Betätigungswelle (8a), die orthogonal zur ersten Betätigungswelle (7a) ist, durch einen Antrieb eines Motors für eine horizontale Substratbewegung in Drehung versetzt wird, so dass sich die Substratstützeinheit unabhängig in die erste Richtung und die zweite Richtung bewegen kann.

6. Plasmafilmbildungsverfahren nach Anspruch 5,
wobei im Schritt (d) entweder ein Abstand zwischen einem Ziel (13) und einer Mitte einer Filmbildungsfläche (4a) des Substrats (4) oder ein Verschiebungsbetrag zwischen einer Mitte des Ziels (13) und der Mitte der Filmbildungsfläche (4a) des Substrats (4) durch Bewegen der Substratstützeinheit in die zweite Richtung oder in die erste Richtung und die zweite Richtung eingestellt wird.

7. Plasmafilmbildungsverfahren nach Anspruch 6,
wobei im Schritt (d), ohne den Abstand zwischen dem Ziel (13) und der Mitte der Filmbildungsfläche (4a) des Substrats (4) zu ändern, die Substratstützeinheit derart bewegt wird, dass der Verschiebungsbetrag zwischen der Mitte des Ziels (13) und der Mitte des Substrats (4) größer oder kleiner wird als der Verschiebungsbetrag zum Zeitpunkt der Filmbildung im Schritt (b).

8. Plasmafilmbildungsverfahren nach Anspruch 5,
wobei im Schritt (b) und im Schritt (e) das Plasma (6) über die gesamte Filmbildungsfläche (4a) des Substrats (4) eingestrahlt wird.

## Revendications

1. Appareil de formation de film de plasma (1) pour l'exécution d'un processus de formation de film par irradiation d'un plasma (6), l'appareil comprenant :
un conteneur sous vide dans lequel le processus de formation de film est exécuté sur un substrat (4) ;
une unité de support de substrat configurée pour supporter le substrat (4) dans le conteneur sous vide et conçue de manière à être rotative le long d'une surface de formation de film (4a) du substrat (4) ;
un arbre rotatif (5) relié à l'unité de support de substrat ;
une unité de génération de plasma (10) communiquant avec le conteneur sous vide, configurée pour générer le plasma (6) et conçue de manière à ce qu'un angle d'irradiation du plasma (6) par rapport à l'arbre rotatif (5) forme un angle aigu ;
une première unité d'entraînement (7) configurée pour déplacer l'unité de support de substrat dans une première direction parallèle à l'arbre rotatif (5) ;
une deuxième unité d'entraînement (8) configurée pour déplacer l'unité de support de substrat dans une deuxième direction orthogonale à l'arbre rotatif (5) ;
une troisième unité d'entraînement (9) configurée pour mettre en rotation l'arbre rotatif (5) ;
dans lequel l'unité de support de substrat est configurée pour être déplacée indépendamment dans la première direction et la deuxième direction ;
**caractérisé en ce que** l'appareil de formation de film de plasma inclut en outre
un premier arbre de commande (7a) mis en rotation par un entraînement de la première unité d'entraînement (7) ; et
un deuxième arbre de commande (8a) orthogonal au premier arbre de commande (7a) et mis en rotation par un entraînement de la deuxième unité d'entraînement (8),
dans lequel l'entraînement de la première unité d'entraînement (7) est configuré pour mettre en rotation le premier arbre de commande (7a) de manière à déplacer l'unité de support de substrat dans la première direction, et dans lequel l'entraînement de la deuxième unité d'entraînement (8) est configuré pour mettre en rotation le deuxième arbre de commande (8a) de manière à déplacer l'unité de support de substrat dans la deuxième direction.

2. Appareil de formation de film de plasma (1) selon la revendication 1, comprenant en outre :
un moteur pour un déplacement vertical du substrat, fourni comme étant la première unité d'entraînement (7) ; et
un moteur pour le déplacement horizontal du substrat, fourni comme étant la deuxième unité d'entraînement (8),
dans lequel l'entraînement du moteur pour le déplacement vertical du substrat est configuré pour mettre en rotation le premier arbre de commande (7a) de manière à actionner l'arbre rotatif (5) dans la première direction et de manière à déplacer l'unité de support de substrat dans la première direction, et dans lequel l'entraînement du moteur pour le déplacement horizontal du substrat est configuré pour mettre en rotation le deuxième arbre de commande (8a) de manière à actionner l'arbre rotatif (5) dans la deuxième direction et de manière à déplacer l'unité de support de substrat dans la deuxième direction.

3. Appareil de formation de film de plasma (1) selon la revendication 2, comprenant en outre :
un moteur pour la rotation du substrat, fourni comme étant la troisième unité d'entraînement (9) ;
un troisième arbre de commande (9a) orthogonal au premier arbre de commande (7a) et mis en rotation par un entraînement du moteur pour la rotation du substrat ;
une unité de mécanisme de conversion (18) configurée pour convertir une rotation du troisième arbre de commande (9a) en une rotation de l'arbre rotatif (5) ; et
une première unité de soufflet (19a) configurée pour recouvrir l'unité de mécanisme de conversion (18) de manière faire communiquer une unité mobile se déplaçant le long de la première direction et le conteneur sous vide, pour entourer une partie de l'arbre rotatif (5) et maintenir un intérieur du conteneur sous vide dans une atmosphère sous vide.

4. Appareil de formation de film de plasma (1) selon la revendication 3, comprenant en outre une deuxième unité de soufflet (19b) configurée pour faire communiquer le conteneur sous vide via la première unité de soufflet (19a) et l'unité mobile et pour entourer une partie du troisième arbre de commande (9a).

5. Procédé de formation de film plasma pour l'exécution d'un processus de formation de film par irradiation d'un plasma (6), comprenant les étapes suivantes :
(a) support d'un substrat (4) par une unité de support de substrat rotative disposée dans un conteneur sous vide ;
(b) après l'étape (a), dans un état où l'unité de support de substrat est mise en rotation par un entraînement d'un moteur pour la rotation du substrat, formation d'un film (21) sur le substrat (4) par irradiation du plasma (6) sur le substrat (4) de telle façon qu'un angle d'irradiation du plasma (6) par rapport à un arbre rotatif (5) de l'unité de support de substrat forme un angle aigu ;
**caractérisé en ce que**
(c) après l'étape (b), retrait du substrat (4) hors du conteneur sous vide et mesure d'une distribution d'épaisseur de film du film (21) formé sur le substrat (4) ;
(d) après l'étape (c), sur la base d'un résultat de mesure de la distribution d'épaisseur de film, déplacement de l'unité de support de substrat dans une deuxième direction orthogonale à une première direction parallèle à l'arbre rotatif (5) ou dans la première direction et la deuxième direction ;
(e) après l'étape (d), dans un état où l'unité de support de substrat est mise en rotation par l'entraînement du moteur pour la rotation du substrat, formation d'un film (21) sur le substrat (4) par irradiation du plasma (6) sur le substrat (4) de telle façon qu'un angle d'irradiation du plasma (6) par rapport à l'arbre rotatif (5) de l'unité de support de substrat forme un angle aigu,
dans lequel, dans l'étape (d), l'unité de support de substrat se déplace dans la première direction en amenant la mise en rotation d'un premier arbre de commande (7a) par un entraînement d'un moteur pour le déplacement vertical du substrat et se déplace dans la deuxième direction en amenant la mise en rotation d'un deuxième arbre de commande (8a) orthogonal au premier arbre de commande (7a) par un entraînement d'un moteur pour le déplacement horizontal du substrat, de telle façon que l'unité de support de substrat peut se déplacer indépendamment dans la première direction et la deuxième direction.

6. Procédé de formation de film plasma selon la revendication 5,
dans lequel, dans l'étape (d), l'un parmi une distance entre une cible (13) et un centre d'une surface de formation de film (4a) du substrat (4) ou un degré de décalage entre un centre de la cible (13) et le centre de la surface de formation de film (4a) du substrat (4) est ajusté par un déplacement de l'unité de support de substrat dans la deuxième direction ou la première direction et la deuxième direction.

7. Procédé de formation de film plasma selon la revendication 6,
dans lequel, dans l'étape (d), sans modifier la distance entre la cible (13) et le centre de la surface de formation de film (4a) du substrat (4), l'unité de support de substrat est déplacée de telle façon que le degré de décalage entre le centre de la cible (13) et le centre du substrat (4) devient supérieur ou inférieur au degré de décalage au moment de la formation de film dans l'étape (b).

8. Procédé de formation de film plasma selon la revendication 5,
dans lequel, dans l'étape (b) et l'étape (e), le plasma (6) est irradié sur l'ensemble de la surface de formation de film (4a) du substrat (4).
